# EUROPÄISCHE PATENTSCHRIFT

(11) **EP 3 178 117 B1**
(45) Veröffentlichungstag und Bekanntmachung des Hinweises auf die Patenterteilung: **15.07.2020**
(21) Anmeldenummer: 15750372.3
(22) Anmeldetag: 07.08.2015
(51) Int. Cl.: H01L 33/48, H01L 23/60, H01L 25/16, H01C 7/12, H01L 33/64, H01L 33/62

(54) **TRÄGER FÜR EINE LED**
SUBMOUNT FOR AN LED
SUPPORT POUR UNE DEL

(30) Priorität: 08.08.2014 DE 102014111363; 22.10.2014 DE 102014115375
(43) Veröffentlichungstag der Anmeldung: 14.06.2017
(73) Patentinhaber: TDK Electronics AG, 81671 München (DE)
(72) Erfinder: FEICHTINGER, Thomas, A-8010 Graz (AT)
(74) Vertreter: Epping - Hermann - Fischer
(86) Internationale Anmeldenummer: PCT/EP2015/068280
(87) Internationale Veröffentlichungsnummer: WO 2016/020537

(56) Entgegenhaltungen:
- WO-A1-2007/058438
- WO-A1-2009/141437
- WO-A1-2009/141439
- US-A1- 2002 001 712
- US-A1- 2005 184 387
- US-A1- 2007 200 133
- US-A1- 2009 020 876
- Jc Mcnulty: "Processing and Reliability Issues for Eutectic AuSn Solder Joints", 41st International symposium on microelectronics (IMAPS 2008), 2 November 2008 (2008-11-02), pages 909-16, XP055588602, Retrieved from the Internet: URL:http://cdn2.hubspot.net/hubfs/1871852/ Content_for_Degreed.com/Previous_Content/P rocessing-and-Reliability-Issues-for-Eutec tic-AuSn-Solder-Joints.pdf?t=1482271815148 [retrieved on 2019-05-14]
- PITTROFF W ET AL: "Flip chip mounting of laser diodes with Au/Sn solder bumps: bumping, self-alignment and laser behavior", ELECTRONIC COMPONENTS AND TECHNOLOGY CONFERENCE, 1997. PROCEEDINGS., 4 7TH SAN JOSE, CA, USA 18-21 MAY 1, NEW YORK, NY, USA,IEEE, US, 18 May 1997 (1997-05-18), pages 1235-1241, XP010233999, DOI: 10.1109/ECTC.1997.606333 ISBN: 978-0-7803-3857-9

## Beschreibung

Die vorliegende Erfindung betrifft einen Träger für eine LED (Leuchtdiode). Der Träger ist dazu geeignet, dass auf ihm eine LED befestigt, beispielsweise gelötet, wird und dass er für eine elektrische Kontaktierung der LED sorgt.

WO 2009/141437 A1 beschreibt eine Bauelementanordnung, bei der ein Halbleiterbauelement auf einem Varistorkörper montiert ist und von diesem getragen wird. Der Varistorkörper ist zum Schutz des elektrischen Bauelementes mit diesem elektrisch kontaktiert, wobei der Varistorkörper das Halbleiterbauelement gegen elektrostatische Entladungen schützt. US 2005/184387 A1 beschreibt auch ein Träger für eine LED.

Beim Design von LED Trägersystemen spielen die Lichtausbeute, die Lebensdauer und das thermische Management eine immer wichtigere Rolle. Neben den funktionalen Herausforderungen gibt es auch thermomechanische und geometrische Probleme zu lösen. Speziell bei mobilen Anwendungen, z.B. bei einem integrierten LED Kamerablitz in Smartphones oder Digitalkameras, soll die LED und der Träger möglichst wenig Platz und eine möglichst geringe Bauhöhe erfordern.

Eine weitere Anforderung an einen Träger für eine LED ist es, dass die Oberseite soweit wie möglich frei von anderen Bauelementen ist, um Abschattungen des von der LED emittierten Lichts zu vermeiden.

Für das thermische Management soll es einen möglichst guten thermischen Kontakt zwischen der LED, dem Träger und der Trägeroberfläche geben.

Der Träger soll zusätzlich eine Schutzvorrichtung gegen elektrostatische Entladungen (ESD = electrostatic discharge) aufweisen, da LEDs sehr sensitiv gegen solche Entladungen sind. Bei den bekannten Trägern für LEDs werden daher entsprechende Schutzbauelemente als diskrete Bauteile auf der Oberseite des Trägers vorgesehen. Diese können allerdings sowohl im Hinblick auf Bauhöhe und Platzbedarf des Trägers als auch im Hinblick auf die Abstrahlcharakteristik einer auf dem Tröger montierten LED nachteilig sein.

Ferner sollte ein Träger für LEDs so gestaltet sein, dass beim Auflöten des Trägers auf einer Platine die Verbindung zwischen der LED und dem Träger nicht aufschmilzt und eine Ausrichtung der LED nicht verändert wird.

Es ist eine Aufgabe der vorliegenden Erfindung, einen verbesserten Träger anzugeben, der beispielsweise zumindest hinsichtlich eines der oben genannten Gesichtspunkte vorteilhaft ist.

Diese Aufgabe wird durch einen Träger gemäß dem vorliegenden Anspruch 1 gelöst.

Es wird ein Träger für eine LED vorgeschlagen, der einen Grundkörper aufweist, wobei eine Schutzvorrichtung zum Schutz einer auf dem Träger befestigten LED gegen elektrostatische Entladungen in den Grundkörper integriert ist.

Der Träger weist ferner eine Oberseite auf, auf der zumindest eine Kontaktfläche zur Befestigung der LED angeordnet ist. Die LED kann durch Löten auf der zumindest einen Kontaktfläche befestigt werden.

Wie aus US 2005/184387 A1 bekannt ist die Schutzvorrichtung somit nicht auf einer Oberseite des Trägers angeordnet, sondern in den Träger integriert. Somit wird die Bauhöhe und der Platzbedarf des Trägers durch die Schutzvorrichtung nicht erhöht. Der Träger ermöglicht somit eine verbesserte Miniaturisierung. Ferner ist die Oberseite des Trägers nunmehr frei von der Schutzvorrichtung, so dass die Lichtabstrahlcharakteristik einer auf dem Träger montierten LED nicht durch die Schutzvorrichtung beeinflusst wird.

Als Schutzvorrichtung kann hier insbesondere eine Vorrichtung bezeichnet werden, die dazu ausgestaltet ist, eine LED vor Beschädigungen durch eine zu hohe anliegende Spannung zu schützen, wie sie etwa bei elektrostatischen Entladungen auftritt. Die Schutzvorrichtung kann dazu ausgestaltet sein, eine solche Spannung abzubauen, ohne die LED zu belasten.

Der Träger ist für die Montage mindestens einer LED geeignet. In weiteren Ausführungsbeispielen, kann der Träger für die Befestigung mehrere LEDs geeignet sein. Beispielsweise kann der Träger Kontaktflächen aufweisen, auf die mehrere, z.B. drei, LEDs gelötet werden können. Die mehreren LEDs können dabei voneinander unterschiedliche Farben haben.

Der Träger weist Kontaktflächen auf, die für eine Befestigung mehrere LEDs geeignet sind, so ist der Träger ferner derart ausgestaltet, dass die auf dem Träger befestigten LEDs über die Kontaktflächen und über auf dem Grundkörper des Trägers aufgebrachte metallische Flächen miteinander verschaltet sind. Die metallischen Flächen dienen zur elektrischen Kontaktierung der LEDs. Die metallischen Flächen erstrecken sich bis zur Unterseite des Trägers und können zur Kontaktierung mit einer Leiterplatine dienen.

Auf der Oberseite des Trägers sind zwei Kontaktflächen angeordnet, wobei die Kontaktflächen derart angeordnet sind, dass auf der Oberseite des Trägers ein mittlerer Bereich zwischen den Kontaktflächen angeordnet ist, der frei von den Kontaktflächen ist, wobei in dem Grundkörper zumindest ein thermisches Via angeordnet sein kann, das mittleren Bereich der Oberseite des Trägers mit der Unterseite des Trägers verbindet. Wird eine LED auf den Kontaktflächen befestigt, so kann sich zwischen dem mittleren Bereich der Oberseite des Trägers und der LED ein Spalt ausbilden. In diesem Spalt kann sich von der LED abgestrahlte Hitze sammeln. Das thermische Via, das den mittleren Bereich der Oberseite mit der Unterseite des Trägers verbindet, kann es nunmehr ermöglichen, diese Hitze effizient abzuleiten.

Die Bereiche der Oberseite, in denen die Kontaktflächen angeordnet sind, sind frei von Vias. Alternativ können auch nur die Bereiche der Oberseite, in denen eine auf den Kontaktflächen zu befestigende LED auf den Kontaktflächen aufliegt, frei von Vias sein. Die Vias können sich negativ auf die Koplanarität und die Oberflächenrauhigkeit der Kontaktflächen auswirken. Um dieses zu vermeiden, können die Vias so angeordnet werden, dass sie nicht in den Bereichen der Kontaktflächen liegen. Auf diese Weise können Kontaktflächen mit geringer Koplanarität und geringer Oberflächenrauhigkeit erreicht werden.

Insbesondere kann die zumindest eine Kontaktfläche eine Koplanarität von weniger als 3 µm und/oder eine Oberflächenrauhigkeit von weniger als 1 µm aufweisen. Dieses kann neben der oben beschriebenen Anordnung der Vias auch dadurch erreicht werden, dass in den Träger integrierte Innenelektroden und/oder in den Träger integrierte metallische Platten eines Hitzeverteilers parallel zu einer Oberseite des Trägers ausgerichtet sind. In diesem Fall schneiden sie die Oberfläche des Trägers nicht und führen somit nicht zu einer Verschlechterung der Ebenheit der Oberfläche.

Der Grundkörper kann ein keramisches Material aufweisen. Insbesondere kann der Grundkörper Zinkoxid-Praseodym (ZnO-Pr) oder Zinkoxid-Wismut (ZnO-Bi) aufweisen. Diese Materialien können es ermöglichen, die Schutzvorrichtung als einen Varistor auszugestalten. Die Materialien weisen einen spannungsabhängigen Widerstand auf. Erst wenn eine Spannung zwischen in den Grundkörper integrierten Innenelektroden anliegt, die einen vorbestimmten Schwellwert überschreitet, wird der Widerstand des keramischen Materials sprunghaft geringer, so dass erst dann ein Strom durch die Schutzvorrichtung fließen kann und die LED so vor der zu hohen Spannung schützen kann.

Die Schutzvorrichtung kann in den Grundkörper integrierte Innenelektroden aufweisen. Die Innenelektroden können Ag-Pd aufweisen. Alternativ sind auch andere Materialien denkbar, beispielsweise Silber, Paladium oder Platin.

Die Innenelektroden können parallel zu der Oberseite des Trägers ausgerichtet sein. Diese Ausrichtung kann es erlauben, die Oberseite maximale eben zu konstruieren.

Die Schutzvorrichtung kann derart ausgestaltet sein, dass ein Strom durch die Schutzvorrichtung fließen kann, wenn die zwischen den Innenelektroden anliegende Spannung einen vorbestimmten Wert überschreitet.

Ferner kann der Träger metallische Flächen zur elektrischen Kontaktierung der LED aufweisen, die auf dem Grundkörper angeordnet sind und die sich von einer Oberseite des Grundkörpers, auf der eine Kontaktfläche zum Auflöten der LED angeordnet ist, bis zu einer Unterseite des Grundkörpers erstrecken, die entgegengesetzt zur Oberseite angeordnet ist.

Die metallische Flächen können dabei insbesondere auf der Oberseite des Grundkörpers direkt mit der Kontaktfläche zum Auflöten der LED elektrisch kontaktiert sein. Bei dem Träger kann es sich ferner um ein SMD Bauteil (SMD = Surface Mounted Device) handeln, das zum Auflöten auf einer Leiterplatine geeignet ist. Dabei kann über die metallischen Flächen, die bis zur Unterseite des Grundkörpers reichen, eine elektrische Kontaktierung mit der Leiterplatine gebildet werden. Die metallischen Flächen können somit eine elektrische Kontaktierung einer auf dem Träger montierten LED mit einer Leiterplatine erstellen.

Ferner sind die metallischen Flächen für das thermische Management vorteilhaft. Im Betrieb wird die auf dem Träger angeordnete LED Hitze abstrahlen. Dabei wird auch Hitze von der Unterseite der LED auf die Oberseite des Trägers gestrahlt. Die Kontaktflächen, die auf der Oberseite des Trägers angeordnet sind, können aus Metall bestehen und eine gute thermische Leitfähigkeit aufweisen. Die Kontaktflächen können insbesondere einen wesentlichen Anteil der auf den Träger gestrahlten Hitze direkt an die metallischen Flächen weiterleiten. Da die metallischen Flächen auf den Außenflächen des Grundkörpers angeordnet sind, können sie die Hitze gut an eine Umgebung des Trägers abstrahlen. Somit ermöglichen es die metallischen Flächen, die Hitze schnell abzuführen und vermeiden so eine Überhitzung von Träger und LED.

Darüber hinaus weist der Träger weitere metallische Flächen auf den Außenflächen des Grundkörpers auf. Diese weiteren metallischen Flächen können zur elektrischen Kontaktierung der LED dienen. Sie können jedoch auch nur eine thermische Aufgabe erfüllen und zur Abführung von Hitze beitragen.

Die metallischen Flächen weisen einen Schichtaufbau aufweisend Silber, Nickel und Gold auf.

Ferner kann ein Hitzeverteiler (Heat Spreader) in den Träger integriert sein. Der Hitzeverteiler kann dazu dienen, von einer auf dem Träger montierten LED abgestrahlte Hitze schnell abzubauen. Auf diese Weise kann der Hitzeverteiler das thermische Management des Trägers erheblich vereinfachen.

Der Hitzeverteiler kann in den Grundkörper integrierte metallische Platten aufweisen, die mit den metallischen Flächen auf dem Grundkörper des Trägers thermisch kontaktiert sind. Von der LED in den Träger eingestrahlte Hitze kann auf diese Weise leicht abgebaut werden, indem die Hitze über die metallischen Platten auf die metallischen Flächen gegeben wird und von dort an die Umgebung abgestrahlt wird. Die metallischen Platten des Hitzeverteilers können Ag-Pd aufweisen.

Die metallischen Platten des Hitzeverteilers können parallel zu der Oberseite des Trägers ausgerichtet sein.

Der Hitzeverteiler kann näher an einer Oberseite des Trägers angeordnet sein als die integrierten Innenelektroden. Es ist entscheidend für die Funktion des Hitzeverteilers, dass dieser möglichst nahe an der LED angeordnet ist, um die von der LED abgestrahlte Hitze gut einfangen zu können.

Auf der Oberseite des Grundkörpers sind Kontaktflächen zum Auflöten einer LED vorgesehen. Auf diesen Kontaktflächen kann eine LED aufgelötet werden, beispielsweise durch eutektisches Löten.

Bei dem Träger kann es sich um ein SMD Bauteil handeln, das zum Auflöten auf einer Leiterplatine geeignet ist.

Der Träger kann Kontaktflächen für eine Befestigung mehrerer LEDs aufweisen. Der Träger kann dabei ferner derart ausgestaltet sein, dass die mehreren LEDs durch eine entsprechende Ausgestaltung der Kontaktflächen miteinander verschaltet sind. Alternativ kann der Träger dabei derart ausgestaltet sein, dass jede der LEDs über die entsprechend ausgestalteten Außenelektroden kontaktiert ist.

Die Kontaktfläche zur Befestigung der LED weist einen Stapelaufbau auf, der zumindest eine Goldschicht und eine Zinnschicht aufweist, wobei in die Höhen der zumindest einen Goldschicht und der zumindest einen Zinnschicht so gewählt sind, dass sich in dem Stapelaufbau ein Verhältnis von Gold zu Zinn zwischen 75:25 und 85:15, vorzugsweise von 80:20, ergibt. Diese Ausgestaltung kann eine Absenkung der Schmelztemperatur, beispielsweise auf 300°C bis 320°C, ermöglichen.

Im Folgenden wird die Erfindung anhand der Figuren näher erläutert.
- Figur 1: zeigt einen Querschnitt durch einen Träger gemäß einem ersten Ausführungsbeispiel.
- Figur 2: zeigt eine Draufsicht auf eine Oberseite des Trägers gemäß dem ersten Ausführungsbeispiel.
- Figur 3: zeigt eine Draufsicht auf eine Unterseite des Trägers gemäß dem ersten Ausführungsbeispiel.
- Figur 4: zeigt eine Seitenansicht des Trägers gemäß dem ersten Ausführungsbeispiel.
- Figur 5: zeigt einen Träger gemäß einem zweiten Ausführungsbeispiel.
- Figuren 6 bis 8: zeigen das Befestigen einer LED auf dem Träger.
- Figur 9: zeigt ein drittes Ausführungsbeispiel des Trägers.
- Figur 10: zeigt ein viertes Ausführungsbeispiel des Trägers.
- Figuren 11 und 12: zeigen ein fünftes Ausführungsbeispiel des Trägers.
- Figuren 13 und 14: zeigen ein sechstes Ausführungsbeispiel des Trägers.

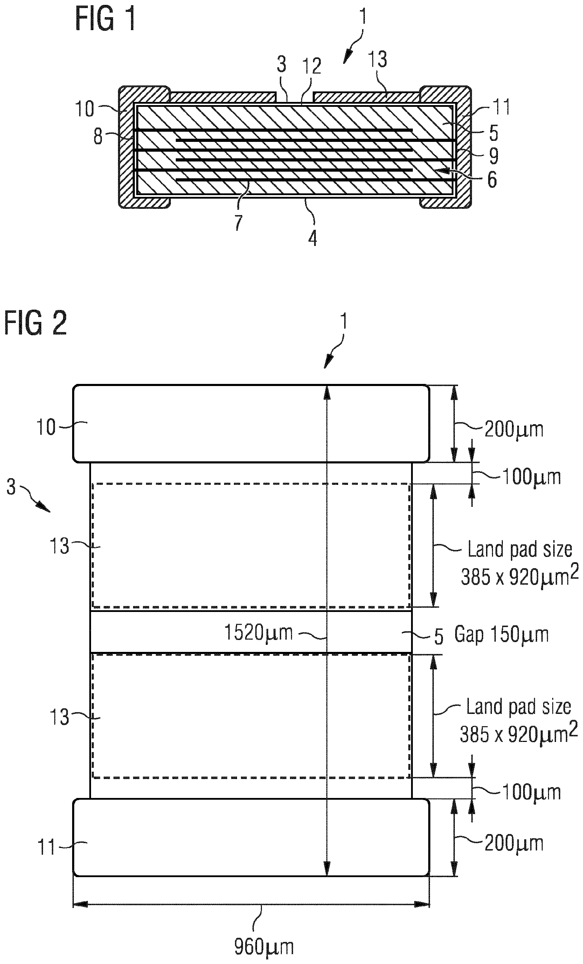

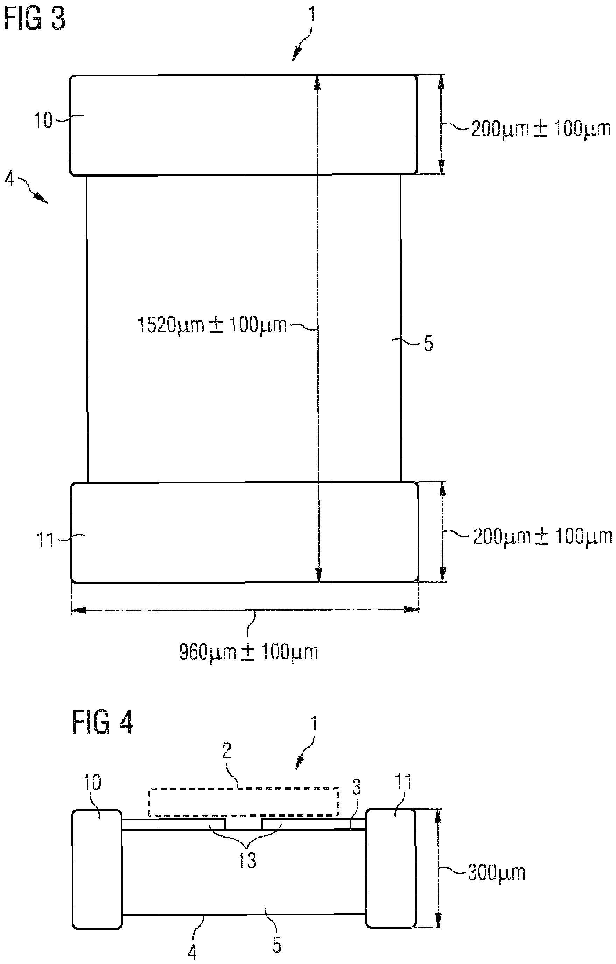

Die Figuren 1 bis 4 zeigen ein erstes Ausführungsbeispiel eines Trägers 1 für eine LED 2. Figur 1 zeigt einen Querschnitt durch den Träger 1. Figur 2 zeigt eine Draufsicht auf eine Oberseite 3 des Trägers 1. Figur 3 zeigt eine Draufsicht auf eine Unterseite 4 des Trägers. Figur 4 zeigt eine Seitenansicht des Trägers 1. In Figur 4 ist ferner eine auf den Träger 1 montierte LED 2 mit einer gestrichelten Linie angedeutet.

Bei dem Träger 1 handelt es sich um ein SMD Bauteil (SMD = Surface-mounted device). Dementsprechend ist der Träger 1 dazu geeignet auf einer Oberfläche einer Leiterplatine (nicht gezeigt) mittels Lot befestigt zu werden.

Der Träger 1 ist ferner dazu ausgestaltet, dass auf ihm eine LED 2 montiert wird. Insbesondere ist der Träger 1 dazu ausgestaltet, dass eine LED 2 auf ihm mittels Löten befestigt wird.

Der Träger 1 weist einen Grundkörper 5 auf. Der Grundkörper 5 ist im Wesentlichen quaderförmig. Der Grundkörper 5 weist ein keramisches Material auf. Insbesondere besteht der Grundkörper 5 aus dem keramischen Material. Bei dem keramischen Material kann es sich um Zinkoxid-Praseodym oder Zinkoxid-Wismut handeln.

In den Grundkörper 5 ist eine Schutzvorrichtung 6 zum Schutz einer auf dem Träger 1 montierten LED 2 gegen elektrostatische Entladungen (ESD = electrostatic discharge) integriert. Die Schutzvorrichtung 6 weist in den Grundkörper 5 integriert Innenelektroden 7 auf.

Jede der Innenelektroden 7 erstreckt sich in einer Ebene parallel zu der Oberseite 3 des Trägers 1, wobei die Oberseite 3 des Trägers 1 die Seite ist, auf der die LED 2 befestigt werden kann. Die Innenelektroden 7 sind also parallel zur Oberseite 3 des Trägers 1 ausgerichtet. Diese Ausrichtung wird auch als vertikale Ausrichtung der Innenelektroden 7 bezeichnet.

In einer Richtung von der Oberseite 3 des Trägers 1 zur Unterseite 4 des Trägers 1, die der Oberseite 3 gegenüberliegt, erstrecken sich die Innenelektroden 7 abwechselnd entweder bis zu einer ersten Stirnseite 8 des Trägers 1 oder bis zu einer zweiten Stirnseite 9 des Trägers 1. Auf der ersten Stirnseite 8 des Trägers 1 ist eine erste metallische Fläche 10 aufgebracht. Die erste metallische Fläche 10 erstreckt sich über die gesamte Länge der ersten Stirnseite 8 und ragt sowohl auf die Oberseite 3 als auch auf die Unterseite 4 des Grundkörpers 5. Auf der zweiten Stirnseite 9 des Trägers 1 ist eine zweite metallische Fläche 11 aufgebracht. Die zweite metallische Fläche 11 erstreckt sich über die gesamte Länge der zweiten Stirnseite 9 und ragt sowohl auf die Oberseite 3 als auch auf die Unterseite 4 des Grundkörpers 5. Die Innenelektroden 7 sind in der Richtung von der Oberseite 3 zur Unterseite 4 abwechselnd mit der ersten metallischen Fläche 10 und der zweiten metallischen Fläche 11 kontaktiert.

Die erste und die zweite metallische Fläche 10, 11 weisen Ag, Ni und Au auf. Die metallischen Fläche 10, 11 weisen einen Stapelaufbau aus Ag, Ni und Au auf, wobei Ag die unterste Schicht bildet.

Die erste und die zweite metallische Fläche 10, 11 sorgen für eine elektrische Kontaktierung einer auf den Träger 1 montierten LED 2. Die Schutzvorrichtung ist somit derart konstruiert, dass eine Spannung, die von den beiden metallischen Fläche 10, 11 an die LED 2 angelegt wird, auch zwischen den Innenelektroden 7 anliegt.

Die Schutzvorrichtung bildet einen Varistor. Durch das keramische Material des Grundkörpers 5 kann bei üblichen Spannungen zwischen den Innenelektroden 7 kein Strom fließen, da das keramische Material einen zu hohen Widerstand aufweist. Dieser Widerstand ist jedoch spannungsabhängig. Übersteigt die zwischen zwei benachbarten Innenelektroden anliegende Spannung einen vorbestimmten Schwellwert, so sinkt der Widerstand des keramischen Materials sprunghaft ab. Nun kann ein Strom zwischen den benachbarten Innenelektroden 7 fließen und die anliegende Spannung kann abgebaut werden. Auf diese Weise wird verhindert, dass beim Auftreten von hohen Spannungen, wie etwa durch eine elektrostatische Entladung, diese Spannung zu Beschädigungen der LED 2 führt. Die Schutzvorrichtung 6 sorgt dafür, dass die Spannung über die Schutzvorrichtung 6 abgebaut wird, ohne die LED 2 zu belasten.

Die Innenelektroden 7 weisen Silber-Paladium (Ag-Pd) auf oder bestehen aus Silber-Paladium.

Ferner ist der Grundkörper 5 von einer Glaspassivierung 12 ummantelt. Die erste und die zweite metallischen Fläche 10, 11 sind außen auf der Glaspassivierung 12 angeordnet. Innenelektroden 7 ragen durch die Glaspassivierung 12 hindurch und sind somit elektrisch mit der ersten und der zweiten metallischen Fläche 10, 11 kontaktiert.

Auf der Oberseite 3 des Trägers 1 sind zwei Kontaktflächen 13 angeordnet. Auf den Kontaktflächen 13 des Trägers 1 kann, wie in Figur 4 angedeutet, eine LED 2 befestigt werden. Die Kontaktflächen 13 sind so ausgestaltet, dass die LED 2 in einem eutektischen Lötprozess auf die Kontaktflächen 13 aufgelötet werden kann. Ein eutektisches Lötverfahren ermöglicht es, den Schmelzpunkt eines Lots abzusenken.

Der Träger 1 kann noch weitere Kontaktflächen 13 zur Montage weiterer LEDs 2 aufweisen.

Die erste und die zweite metallische Fläche 10, 11 weisen ein größere Dicke als die Kontaktflächen 13 auf.

Erfindungsgemäß weisen die Kontaktflächen 13 einen Stapelaufbau auf, der zumindest eine Gold aufweisende Schicht und eine Zinn aufweisende Schicht aufweist. Somit besteht zumindest eine Schicht des Stapelaufbaus aus Gold und zumindest eine Schicht aus Zinn.

Der Stapelaufbau kann beispielsweise eine unmittelbar auf der Oberseite 3 angeordnete Titan-Grundschicht aufweisen. Über der Titan-Grundschicht kann eine Nickel-Schicht angeordnet sein. Über der Nickel-Schicht können - in dieser Reihenfolge - eine erste Goldschicht, eine erste Zinnschicht, eine zweite Goldschicht und eine zweite Zinnschicht angeordnet sein. Die Titan-Grundschicht kann mittels Sputtern erzeugt werden und beispielsweise eine Höhe von 0,1 µm aufweisen. Die weiteren Schichten des Stapelaufbaus können galvanisch erzeugt werden. Die Nickelschicht kann eine Höhe von 2 µm aufweisen. Die Goldschichten können eine Höhe von 0,8 µm aufweisen. Die Zinnschichten können eine Höhe von 0,2 µm aufweisen.

Die Höhen der Gold- und der Zinnschichten sind so aufeinander abgestimmt, dass sich im Stapelaufbau der Kontaktflächen 13 ein Verhältnis von Gold zu Zinn zwischen 75:25 und 85:15, vorzugsweise von 80:20, ergibt. Dieses Verhältnis führt zu einer Absenkung der Aufschmelztemperatur der Kontaktflächen. Auf diese Weise kann eine Aufschmelztemperatur zwischen 300 °C und 320 °C erreicht werden. Auf diese Weise kann ein eutektisches Löten ermöglicht werden.

Durch das Aufsputtern einer Grundschicht und das anschließende galvanische Erzeugen darüber liegender weiterer Schichten der Kontaktflächen 13 können Kontaktflächen 13 gefertigt werden, die eine besonders geringe Koplanarität und eine besonders geringe Oberflächenrauhigkeit aufweisen. Beispielsweise können die Kontaktflächen 13 eine Koplanarität von weniger als 3 µm aufweisen. Ferner können die Kontaktflächen 13 eine Oberflächenrauhigkeit von weniger als 1 µm aufweisen.

Der Träger 1 weist eine Höhe zwischen 100 µm und 500 µm auf, vorzugsweise zwischen 150 µm und 350 µm. Die Höhe gibt dabei den Abstand von der Oberseite 3 zu der Unterseite 4 des Trägers 1 an. Der Träger 1 weist ferner eine Breite zwischen 200 µm und 2000 µm, vorzugsweise zwischen 350 µm und 1600 µm auf. Der Träger 1 weist ferner eine Länge zwischen 100 µm und 1500 µm, vorzugsweise zwischen 150 µm und 1000 µm auf. Die Breite gibt dabei die Ausdehnung des Trägers 1 in Richtung der Flächennormale der Stirnseiten 8, 9 an. Die Länge gibt die Ausdehnung des Trägers 1 in einer Richtung entlang der Stirnseiten 8, 9 und senkrecht zur Richtung der Verbindung von Ober- und Unterseite 3, 4 an.

Ferner kann der Träger 1 auf seiner Unterseite 4 zumindest eine thermische Kontaktfläche (nicht gezeigt) aufweisen. Die thermische Kontaktfläche kann eine thermische Kontaktierung des Trägers 1 mit einer Leiterplatine, auf der der Träger 1 montiert ist, verbessern. Die thermische Kontaktfläche kann Ag, Ni und/oder Au aufweisen. Insbesondere kann die thermische Kontaktfläche einen Stapelaufbau aus Ag, Ni und Au aufweisen, wobei Ag unmittelbar auf dem Grundkörper 5 angeordnet sein kann. Statt Au kann auch Sn verwendet werden.

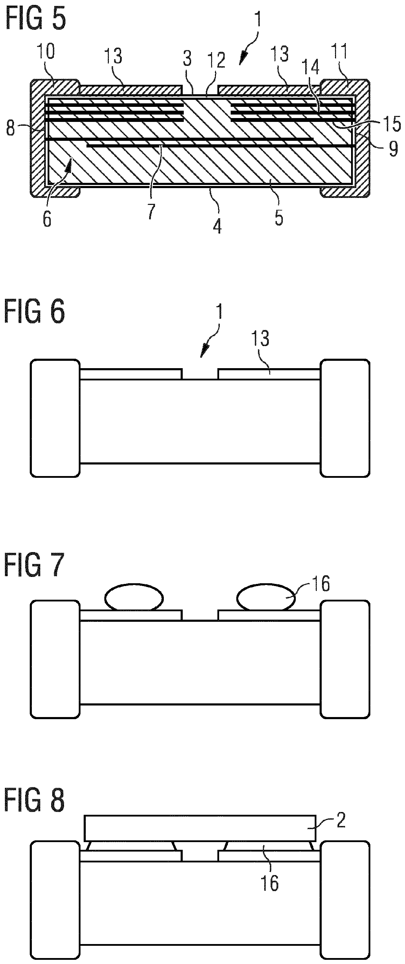

Figur 5 zeigt ein zweites Ausführungsbeispiel des Trägers 1. Der Träger 1 gemäß dem zweiten Ausführungsbeispiel weist zusätzlich einen Hitzeverteiler 14 (Heat Spreader) auf, der in den Grundkörper 5 des Trägers 1 integriert ist. Der Hitzeverteiler 14 weist metallische Platten 15 auf. Die metallischen Platten 15 des Hitzeverteilers 14 sind in zwei Gruppen untergliedert. Die metallischen Platten 15 der ersten Gruppe sind mit der ersten metallischen Fläche 10 auf der ersten Stirnseite 8 verbunden. Die metallischen Platten 15 der zweiten Gruppe sind mit der zweiten metallischen Fläche 11 auf der zweiten Stirnseite 9 verbunden.

Im Betrieb kann eine auf dem Träger 1 montierte LED 2 viel Hitze abstrahlen. Dabei wird die Hitze auch in den Träger 1 abgestrahlt. Die metallischen Platten 15 des Hitzeverteilers 14 dienen dazu, entstehende Hitze schnell abzuführen. Sie unterstützen dabei die Hitzeabfuhr über die metallischen Flächen 10, 11 und sorgen somit für ein noch besseres Abführen von Hitze.

Auf diese Weise kann eine Überhitzung einer auf dem Träger 1 montierten LED 2 sowie des Grundkörpers 5 des Trägers 1 vermieden werden. Die Hitze wird von den metallischen Platten 15 auf die jeweilige metallische Fläche 10, 11 abgeführt, von wo aus die Hitze leichter abgestrahlt werden kann. Die metallischen Platten 15 des Hitzeverteilers 14 weisen Silber-Paladium auf oder bestehen aus Silber-Paladium.

Die Figuren 6, 7 und 8 zeigen, wie eine LED 2 auf dem Träger 1 montiert wird. In Figur 6 ist zunächst der Träger 1 ohne LED 2 abgebildet. Figur 7 zeigt den Träger 1 nach einem ersten Montageschritt, in dem Lot 16 auf den Kontaktflächen 13 des Trägers 1 aufgebracht wurde. Figur 8 zeigt den Träger 1 nachdem die LED 2 auf dem Träger 1 befestigt wurde. Die LED 2 wird auf die Kontaktflächen 13 aufgesetzt, wobei das Lot 16 für eine mechanische Verbindung des Trägers 1 mit der LED 2 sorgt. Anschließend wird das Lot 16 ausgehärtet.

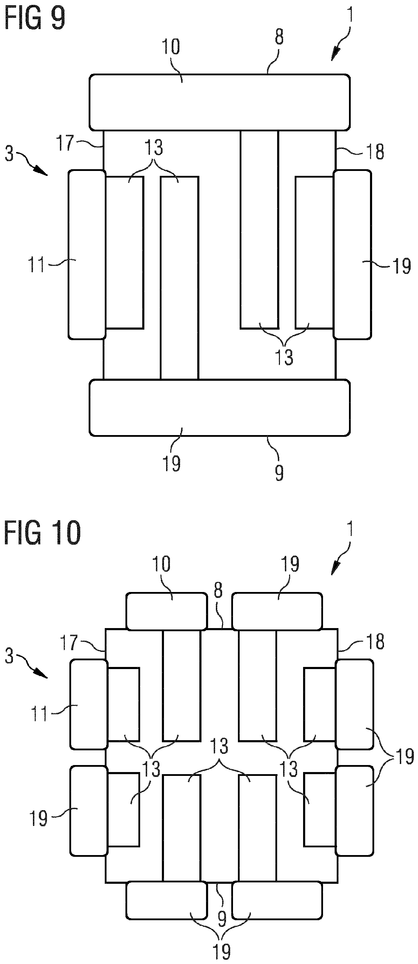

Figur 9 zeigt ein drittes Ausführungsbeispiel eines Trägers 1. In Figur 9 ist eine Draufsicht auf die Oberseite 3 des Trägers 1 dargestellt. Auf der Oberseite 3 sind insgesamt vier Kontaktflächen 13 angeordnet. Jede der Kontaktflächen 13 ist über je eine metallische Fläche 10, 11, 19 elektrisch kontaktiert. Der Träger weist zu diesem Zweck neben der ersten und zweien metallischen Fläche 10, 11, weitere metallische Flächen 19 auf. Dabei erstreckt sich jede der metallischen Flächen 10, 11, 19 von der Oberseite 3 des Trägers 1 über eine der Stirnseiten 8, 9 oder eine der Außenseiten 17, 18 bis zur Unterseite 4 des Trägers 1. Die Außenseiten 17, 18 verbinden jeweils die Ober- und Unterseite 3, 4 und sind senkrecht zu den Stirnseiten 8, 9. Der in Figur 9 gezeigt Träger 1 ist zur Befestigung von zwei LEDs ausgelegt.

Figur 10 zeigt ein viertes Ausführungsbeispiel eines Trägers 1. Auch in Figur 10 ist eine Draufsicht auf die Oberseite 3 des Trägers 1 dargestellt. Auf der Oberseite 3 sind insgesamt acht Kontaktflächen 13 angeordnet, so dass der Träger zur Bestückung mit vier LEDs geeignet ist. Jede der Kontaktflächen 13 ist über je eine metallische Fläche 10, 11, 19 elektrisch kontaktiert. Dabei erstreckt sich jede der metallischen Flächen 10, 11, 19 von der Oberseite 3 des Trägers 1 über eine der Stirnseiten 8, 9 oder eine der Außenseiten bis zur Unterseite 4 des Trägers 1.

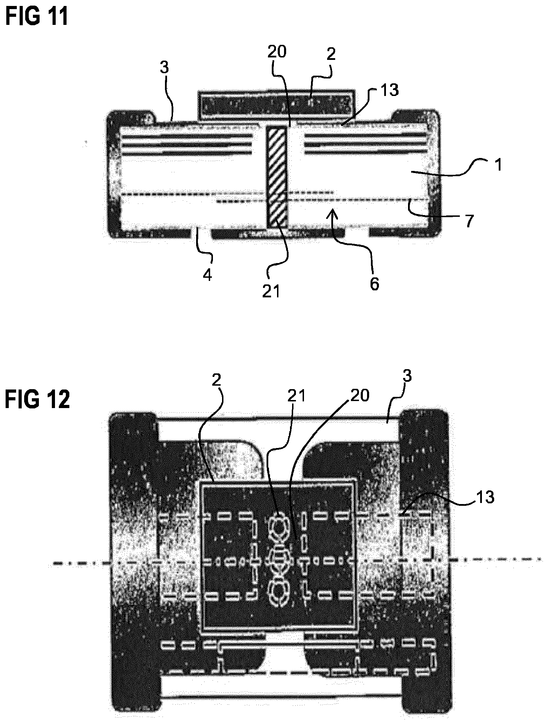

Die Figuren 11 und 12 zeigen ein fünftes Ausführungsbeispiel des Trägers 1. Figur 11 zeigt dabei einen Querschnitt und Figur 12 zeigt eine Draufsicht.

Auf der Oberseite 3 des Trägers 1 sind zwei Kontaktflächen 13 angeordnet, auf denen eine LED aufgelötet werden kann. Zwischen den Kontaktflächen befindet sich ein mittlerer Bereich 20 der Oberseite 3. Ist die LED 2 auf den Kontaktflächen 13 befestigt, so bildet sich in dem mittleren Bereich ein Spalt zwischen LED 2 und Träger 1 aus.

Der Träger weist ferner zumindest ein thermisches Via 21 auf, das den mittleren Bereich der Oberseite 3 mit der Unterseite 4 des Trägers verbindet. Hier weist der Träger 1 drei thermische Vias auf. Die thermischen Vias ermöglichen es, von der LED 2 in den Spalt abgestrahlte Hitze, zur Unterseite abzuleiten. Somit ermöglichen die thermischen Vias eine thermische Verbesserung des Aufbaus.

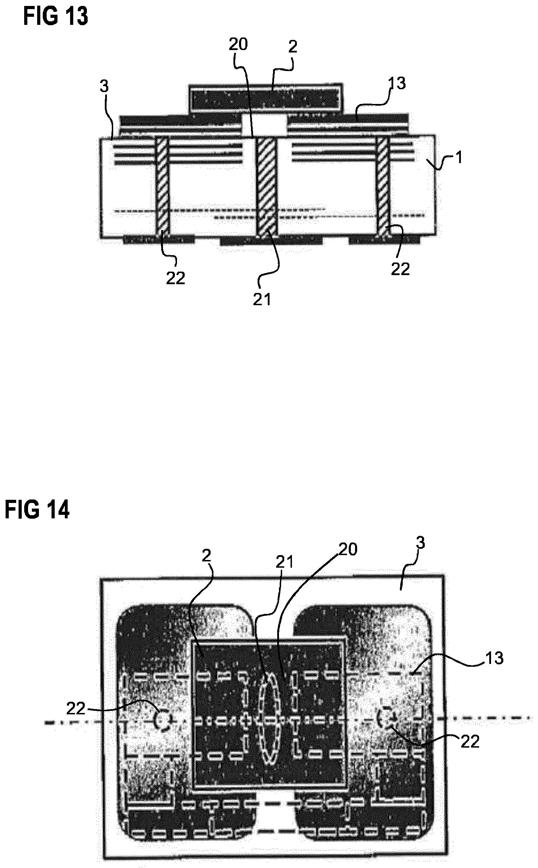

Die Figuren 13 und 14 zeigen ein sechstes Ausführungsbeispiel des Trägers.

Der Träger weist keine metallischen Flächen 10, 11 auf. Stattdessen weist der Träger weitere Vias 22 auf, die zur Kontaktierung der Kontaktflächen 13 und zur Kontaktierung der in den Grundkörper integrierten Innenelektroden dienen. Die weiteren Vias 22 liegen an den Kontaktflächen 13 in den Bereichen an, auf denen die LED 2 nicht unmittelbar aufliegt. Somit stören sie nicht die Koplanarität und die Oberflächenrauhigkeit der der Kontaktflächen 13 in den Bereichen, in denen die LED 2 auf den Kontaktflächen 13 aufliegt.

Die Kontaktflächen 13 weisen den oben beschriebenen Stapelaufbau auf, der ein Verhältnis von Gold zu Zinn von 80:20 aufweist.

### Bezugszeichenliste

- 1: Träger
- 2: LED
- 3: Oberseite
- 4: Unterseite
- 5: Grundkörper
- 6: Schutzvorrichtung
- 7: Innenelektroden
- 8: erste Stirnseite
- 9: zweite Stirnseite
- 10: erste metallische Fläche
- 11: zweite metallische Fläche
- 12: Glaspassivierung
- 13: Kontaktfläche
- 14: Hitzeverteiler
- 15: metallische Platte
- 16: Lot
- 17: Außenseite
- 18: Außenseite
- 19: weitere metallische Fläche
- 20: mittlerer Bereich
- 21: thermisches Via
- 22: weiteres Via

## Patentansprüche

1. Träger (1) für eine LED (2),
aufweisend einen Grundkörper (5),
wobei der Träger eine Oberseite (3) aufweist, auf der zumindest eine Kontaktfläche (13) zur Befestigung einer LED (2) angeordnet ist, wobei die Kontaktfläche zur Befestigung der LED einen Stapelaufbau aufweist, der zumindest eine Goldschicht und eine Zinnschicht aufweist, wobei die Höhen der zumindest einen Goldschicht und der zumindest einen Zinnschicht so gewählt sind, dass sich in dem Stapelaufbau ein Verhältnis von Gold zu Zinn zwischen 75:25 und 85:15 ergibt,
wobei eine Schutzvorrichtung (6) zum Schutz einer auf dem Träger (1) befestigten LED (2) gegen elektrostatische Entladungen in den Grundkörper (5) integriert ist,
wobei der Träger (1) metallische Flächen (10, 11) zur elektrischen Kontaktierung der LED (2) aufweist, die auf dem Grundkörper (5) angeordnet sind und die sich von einer Oberseite (3) des Grundkörpers (5) bis zu einer Unterseite (4) des Grundkörpers (5) erstrecken,
wobei die metallischen Flächen (10, 11) einen Schichtaufbau aufweisend Silber, Nickel und Gold aufweisen.

2. Träger (1) gemäß Anspruch 1,
wobei auf der Oberseite (3) des Trägers (1) eine zweite Kontaktfläche (13) angeordnet ist, wobei die Kontaktflächen (13) derart angeordnet sind, dass auf der Oberseite (3) des Trägers (1) ein mittlerer Bereich (20) zwischen den Kontaktflächen (13) angeordnet ist, der frei von den Kontaktflächen (13) ist,
wobei in dem Grundkörper (5) zumindest ein thermisches Via (21) angeordnet ist, das den mittleren Bereich (20) der Oberseite (3) des Trägers (1) mit der Unterseite (4) des Trägers (1) verbindet.

3. Träger (1) gemäß Anspruch 2,
wobei die Bereiche der Oberseite (3), in denen die Kontaktflächen (13) angeordnet sind, frei von Vias (21, 22) sind.

4. Träger (1) gemäß einem der vorherigen Ansprüche,
wobei die zumindest eine Kontaktfläche (13) eine Koplanarität von weniger als 3 µm und/oder eine Oberflächenrauhigkeit von weniger als 1 µm aufweist.

5. Träger (1) gemäß dem einem der vorherigen Ansprüche,
wobei der Grundkörper (5) ein keramisches Material aufweist, insbesondere Zinkoxid-Praseodym oder Zinkoxid-Wismut.

6. Träger (1) gemäß einem der vorherigen Ansprüche,
wobei die Schutzvorrichtung (6) in den Grundkörper (5) integrierte Innenelektroden (7) aufweist, und
wobei die Innenelektroden (4) parallel zu der Oberseite (3) des Trägers (1) ausgerichtet sind.

7. Träger (1) gemäß dem Anspruch 6,
wobei die Schutzvorrichtung (6) derart ausgestaltet ist, dass ein Strom durch die Schutzvorrichtung (6) fließen kann, wenn die zwischen den Innenelektroden (7) anliegende Spannung einen vorbestimmten Wert überschreitet.

8. Träger (1) gemäß einem der vorherigen Ansprüche,
wobei ein Hitzeverteiler (14) in den Träger (1) integriert ist, der in den Grundkörper (5) integrierte metallische Platten (15) aufweist.

9. Träger (1) gemäß dem Anspruch 8,
wobei die metallischen Platten (15) des Hitzeverteilers (14) parallel zu der Oberseite (3) des Trägers (1) ausgerichtet sind.

10. Träger (1) gemäß einem der Ansprüche 8 oder 9,
wobei die metallische Platten (15) des Hitzeverteilers mit den metallischen Flächen (10, 11) kontaktiert sind.

11. Träger (1) gemäß einem der Ansprüche 8 bis 10,
wobei die Schutzvorrichtung (6) in den Grundkörper (5) integrierte Innenelektroden (7) aufweist, und
wobei der Hitzeverteiler (14) näher an einer Oberseite (3) des Trägers (1) angeordnet ist als die integrierten Innenelektroden (7).

12. Träger (1) gemäß einem der vorherigen Ansprüche,
wobei es sich bei dem Träger (1) um ein SMD Bauteil handelt, das zum Auflöten auf einer Leiterplatine geeignet ist.

13. Träger (1) gemäß einem der vorherigen Ansprüche,
der Kontaktflächen (13) für eine Befestigung mehrerer LEDs aufweist.

14. Träger (1) gemäß einem der vorherigen Ansprüche,
wobei die Höhen der zumindest einen Goldschicht und der zumindest einen Zinnschicht so gewählt sind, dass sich in dem Stapelaufbau ein Verhältnis von Gold zu Zinn von 80:20 ergibt.

## Claims

1. Carrier (1) for an LED (2),
having a main body (5),
wherein the carrier has an upper side (3), on which at least one contact area (13) for attaching an LED (2) is arranged, wherein the contact area for attaching the LED has a stack construction having at least one gold layer and one tin layer, wherein the heights of the at least one gold layer and of the at least one tin layer are chosen such that a ratio of gold to tin of between 75:25 and 85:15 is obtained in the stack construction,
wherein a protective apparatus (6) for protecting an LED (2) attached to the carrier (1) from electrostatic discharges is integrated into the main body (5),
wherein the carrier (1) has metallic areas (10, 11) for electrical contact with the LED (2), which are arranged on the main body (5) and extend from an upper side (3) of the main body (5) to a lower side (4) of the main body (5),
wherein the metallic areas (10, 11) have a layer structure having silver, nickel and gold.

2. Carrier (1) according to Claim 1,
wherein a second contact area (13) is arranged on the upper side (3) of the carrier (1), wherein the contact areas (13) are arranged such that a middle region (20) that is free from the contact areas (13) is arranged on the upper side (3) of the carrier (1) between the contact areas (13),
wherein at least one thermal via (21) connecting the middle region (20) of the upper side (3) of the carrier (1) to the lower side (4) of the carrier (1) is arranged in the main body (5).

3. Carrier (1) according to Claim 2,
wherein the regions of the upper side (3) in which the contact areas (13) are arranged are free from vias (21, 22) .

4. Carrier (1) according to one of the preceding claims,
wherein the at least one contact area (13) has a coplanarity of less than 3 µm and/or a surface roughness of less than 1 µm.

5. Carrier (1) according to one of the preceding claims,
wherein the main body (5) has a ceramic material, in particular zinc oxide praseodymium or zinc oxide bismuth.

6. Carrier (1) according to one of the preceding claims,
wherein the protective apparatus (6) has inner electrodes (7) integrated into the main body (5) and
wherein the inner electrodes (4) are oriented parallel to the upper side (3) of the carrier (1).

7. Carrier (1) according to Claim 6,
wherein the protective apparatus (6) is designed such that a current can flow through the protective apparatus (6) if the voltage applied between the inner electrodes (7) exceeds a predetermined value.

8. Carrier (1) according to one of the preceding claims,
wherein a heat distributor (14) having metallic plates (15) integrated into the main body (5) is integrated into the carrier (1).

9. Carrier (1) according to Claim 8,
wherein the metallic plates (15) of the heat distributor (14) are oriented parallel to the upper side (3) of the carrier (1).

10. Carrier (1) according to either of Claims 8 and 9,
wherein the metallic plates (15) of the heat distributor are in contact with the metallic areas (10, 11).

11. Carrier (1) according to one of Claims 8 to 10,
wherein the protective apparatus (6) has inner electrodes (7) integrated into the main body (5) and
wherein the heat distributor (14) is arranged closer to an upper side (3) of the carrier (1) than the integrated inner electrodes (7).

12. Carrier (1) according to one of the preceding claims,
wherein the carrier (1) is an SMD component suitable for being soldered to a printed circuit board.

13. Carrier (1) according to one of the preceding claims,
having contact areas (13) for attaching a plurality of LEDs.

14. Carrier (1) according to one of the preceding claims,
wherein the heights of the at least one gold layer and of the at least one tin layer are chosen such that a ratio of gold to tin of 80:20 is obtained in the stack construction.

## Revendications

1. Élément porteur (1) pour une LED (2),
possédant un corps de base (5),
l'élément porteur possédant un côté supérieur (3) sur lequel est disposée au moins une surface de contact (13) servant à la fixation d'une LED (2), la surface de contact servant à la fixation de la LED possédant une structure empilée qui possède au moins une couche d'or et une couche d'étain, les hauteurs de l'au moins une couche d'or et de l'au moins une couche d'étain étant choisies de telle sorte qu'un rapport de l'or à l'étain compris entre 75:25 et 85:15 est obtenu dans la structure empilée,
un dispositif de protection (6) destiné à protéger une LED (2) fixée sur l'élément porteur (1) contre les décharges électrostatiques étant intégré dans le corps de base (5),
l'élément porteur (1) possédant des surfaces métalliques (10, 11) destinées à l'établissement du contact électrique avec la LED (2), lesquelles sont disposées sur le corps de base (5) et s'étendent d'un côté supérieur (3) du corps de base (5) à un côté inférieur (4) du corps de base (5),
les surfaces métalliques (10, 11) possédant une structure en couches qui présente de l'argent, du nickel et de l'or.

2. Élément porteur (1) selon la revendication 1,
une surface de contact (13) étant disposée sur le côté supérieur (3) de l'élément porteur (1), les surfaces de contact (13) étant disposées de telle sorte que sur le côté supérieur (3) de l'élément porteur (1), une zone centrale (20) qui est exempte des surfaces de contact (13) est disposée entre les surfaces de contact (13),
au moins un trou d'interconnexion (21) thermique étant disposé dans le corps de base (5), lequel relie la zone centrale (20) du côté supérieur (3) de l'élément porteur (1) au côté inférieur (4) de l'élément porteur (1).

3. Élément porteur (1) selon la revendication 2,
les zones du côté supérieur (3) dans lesquelles sont disposées les surfaces de contact (13) étant exemptes de trous d'interconnexion (21, 22).

4. Élément porteur (1) selon l'une des revendications précédentes,
l'au moins une surface de contact (13) présentant une coplanarité inférieure à 3 µm et/ou une rugosité de surface inférieure à 1 µm.

5. Élément porteur (1) selon l'une des revendications précédentes,
le corps de base (5) possédant un matériau céramique, notamment de l'oxyde de zinc-praséodyme ou de l'oxyde de zinc-bismuth.

6. Élément porteur (1) selon l'une des revendications précédentes,
le dispositif de protection (6) possédant des électrodes internes (7) intégrées dans le corps de base (5), et les électrodes internes (4) étant orientées parallèlement au côté supérieur (3) de l'élément porteur (1).

7. Élément porteur (1) selon la revendication 6,
le dispositif de protection (6) étant configuré de telle sorte qu'un courant peut circuler à travers le dispositif de protection (6) lorsque la tension appliquée entre les électrodes internes (7) dépasse une valeur prédéterminée.

8. Élément porteur (1) selon l'une des revendications précédentes, un distributeur de chaleur (14) étant intégré dans l'élément porteur (1), lequel possède des plaques métalliques (15) intégrées dans le corps de base (5).

9. Élément porteur (1) selon la revendication 8,
les plaques métalliques (15) du distributeur de chaleur (14) étant orientées parallèlement au côté supérieur (3) de l'élément porteur (1).

10. Élément porteur (1) selon l'une des revendications 8 et 9,
les plaques métalliques (15) du distributeur de chaleur (14) étant mises en contact avec les surfaces métalliques (10, 11).

11. Élément porteur (1) selon l'une des revendications 8 à 10,
le dispositif de protection (6) possédant des électrodes internes (7) intégrées dans le corps de base (5), et
le distributeur de chaleur (14) étant disposé plus près d'un côté supérieur (3) de l'élément porteur (1) que les électrodes internes (7) intégrées.

12. Élément porteur (1) selon l'une des revendications précédentes,
l'élément porteur (1) étant un composant CMS qui est adapté pour être brasé sur une carte de circuit imprimé.

13. Élément porteur (1) selon l'une des revendications précédentes,
lequel possède des surfaces de contact (13) pour une fixation de plusieurs LED.

14. Élément porteur (1) selon l'une des revendications précédentes,
les hauteurs de l'au moins une couche d'or et de l'au moins une couche d'étain étant choisies de telle sorte qu'un rapport de l'or à l'étain de 80:20 est obtenu dans la structure empilée.
